## Europäisches Patentamt
## European Patent Office
## Office européen des brevets

(11) Veröffentlichungsnummer: **0 195 106**
**B1**

(12) **EUROPÄISCHE PATENTSCHRIFT**

(45) Veröffentlichungstag der Patentschrift:
21.06.89

(51) Int. Cl.⁴: **G 03 F 7/08**, G 03 F 7/26

(21) Anmeldenummer: 85103349.8

(22) Anmeldetag: 22.03.85

(54) Herstellung einer Abhebemaske und ihre Anwendung.

(43) Veröffentlichungstag der Anmeldung:
24.09.86 Patentblatt 86/39

(45) Bekanntmachung des Hinweises auf die Patenterteilung:
21.06.89 Patentblatt 89/25

(84) Benannte Vertragsstaaten:
**DE FR GB**

(73) Patentinhaber: **IBM DEUTSCHLAND GMBH, Pascalstrasse 100, D-7000 Stuttgart 80 (DE)**
(84) Benannte Vertragsstaaten: **DE**

(73) Patentinhaber: **International Business Machines Corporation, Old Orchard Road, Armonk, N.Y. 10504 (US)**
(84) Benannte Vertragsstaaten: **FR GB**

(72) Erfinder: **Moritz, Holger, Ahornstrasse 68, D-7031 Holzgerlingen (DE)**
Erfinder: **Pfeiffer, Gerd, Aichtalstrasse 41, D-7031 Holzgerlingen (DE)**

(56) Entgegenhaltungen:
EP-A-0 021 719
DD-A-143 920
DD-A-143 921
FR-A-2 316 625
FR-A-2 523 324
NL-A-8 001 561

XEROX DISCLOSURE JOURNAL, Band 7, Nr. 4, Juli/August 1982, Seiten 293-294, Stanford, Connecticut, US; R.B. RAUCH: "A double exposure technique for positive resist lift-off"
IBM TECHNICAL DISCLOSURE BULLETIN, Band 23, Nr. 5, Oktober 1980, Seite 1839, New York, US; C.J. HAMEL et al.: "Negative-acting positive photoresist"
RESEARCH DISCLOSURE, Nr. 242, Juni 1984, Seite 240, Nr. 24205, Havant, Hampshire, GB: "An image reversible positive photoresist with chemically induced high temperature rheological stability"
IBM TECHNICAL DISCLOSURE BULLETIN, Band 26, Nr. 6, November 1983, Seite 2679, New York, US;

(74) Vertreter: **Oechssler, Dietrich, Dr. rer. nat., IBM Deutschland GmbH Patentwesen und Urheberrecht Schönaicher Strasse 220, D-7030 Böblingen (DE)**

(56) Entgegenhaltungen: (Fortsetzung)
K.L. HOLLAND et al.: "Prevention of in-vacuo resist outgassing"
JOURNAL OF THE ELECTROCHEMICAL SOCIETY, Juni 1982, Seiten 1379-1381; R.Allen et al.: "Deep U.V. hardening of positive photoresist patterns"
IBM TECHNICAL DISCLOSURE BULLETIN, Band 26, Nr. 7B, December 1983, Seite 3972, New York, US;
D.A. BADAMI et al.: "Skirt-free metalization and improved step coverage by using diazonaphthol quinone novolak resists in an image reversal process"
J. ELECTROCHEM. SOC. SOLID-STATE SCIENCE AND TECHNOLOGY, Band 126, Nr. 11, November 1979, Seiten 2026-2031; J.M. SHAW et al.: "Developer temperature effects on E-beam and optically exposed positive photoresist"
IBM TECHNICAL DISCLOSURE BULLETIN, Band 24, Nr. 9, February 1982, Seite 4726, New York, US; C.B. FIELD et al.: "Enhanced thermal stability of simplified lift-off structures"
IBM TECHNICAL DISCLOSURE BULLETIN, Band 20, Nr. 7, December 1977, Seite 2809, New York, US; J. PACANSKY: "Negative or positive photoresist"
IBM TECHNICAL DISCLOSURE BULLETIN, Band 23, Nr. 2, Juli 1980, Seite 773, New York, US; H. HIRAOKA: "Poly(p-vinyl phenol) and brominated poly(p-vinyl phenol) as host resins for electron beam resists"
IEEE TRANSACTIONS ON ELECTRON DEVICES, Band ED-32, Nr. 3, März 1985, Seiten 672-676, New York, US; H. MORITZ: "Optical single layer lift-off process"
MICROELECTRONICS ENGINEERING, Band 1, Nr. 4, Dezember 1983, Seite 289-293, Elsevier Science Publishers B.V., NL; S.A. MACDONALD et al.: "Advances in the design of organic resist materials"

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zum Herstellen einer Abhebemaske, bei dem ein eine schwache Base enthaltender Positivlack auf ein Substrat aufgebracht, bildmäßig bestrahlt, gehärtet, ganzflächig bestrahlt und entwickelt wird, und eine Anwendung der hergestellten Maske.

Abhebemasken werden insbesondere beim Herstellen von Leiterzugmustern eingesetzt. Dabei wird die Abhebemaske, welche entsprechend dem Negativ des gewünschten Leiterzugmusters ausgebildet ist, ganzflächig mit Metall bedampft, und anschließend wird die Abhebemaske in einem geeigneten Lösungsmittel aufgelöst und damit das auf ihr liegende Metall abgehoben. Übrig bleibt das in den Maskenöffnungen niedergeschlagene Metall.

Es ist unbedingt erforderlich, daß die Wände in den Öffnungen der Abhebemaske überhängen. Ist dies nicht der Fall, so hüllt das aufgedampfte Metall das Lackmuster von oben und von der Seite vollständig ein, mit der Folge, daß das Lösungsmittel auf die Abhebemaske nicht einwirken kann.

Verfahren zum Herstellen von Abhebemasken, welche die genannte Voraussetzung erfüllen, sind beispielsweise in dem Aufsatz "A VLSI bipolar metallization design with three-level wiring and area array solder connections" von L. J. Freed u. a., veröffentlicht im IBM Journal of Research and Development Bd. 26, Nr. 3, Mai 1982, Seite 362 und in der deutschen Patentschrift 2 529 054 beschrieben. Bei dem in dem Aufsatz beschriebenen Verfahren müssen Schichten mittels chemischem Niederschlagen aus der Dampfphase (CVD) aufgebracht und mittels reaktiven Ionenätzens (RIE) geätzt werden, d. h. es ist ein beachtlicher apparativer Aufwand notwendig. Die so hergestellte Maske besteht aus vier Schichten. Bei dem in der Patentschrift beschriebenen Verfahren besteht die Abhebemaske nur aus einer Schicht, und der apparative Aufwand ist gering. Es wird dabei so vorgegangen, daß ein Positivlackmaterial mit einem Gehalt an 1-Hydroxyäthyl-2-alkylimidazolin auf eine Unterlage aufgetragen, mit aktinischer Strahlung bildmäßig belichtet, anschließend eine ausreichende Zeit auf eine ausreichende Temperatur erhitzt, anschließend uniform mit aktinischer Strahlung belichtet und schließlich entwickelt wird. In dem Artikel "Image Reversal: The Production of a Negative Image in a Positive Photoresist" haben S. A. Mac Donald u. a. darauf hingewiesen, daß der in dem Patent beschriebene Prozeß auch funktioniert, wenn statt 1-Hydroxyäthyl-2-alkylimidazolin eine andere schwache Base, wie z. B. Imidazol oder Triäthanolamin eingesetzt wird.

Problematisch bei den bekannten Abhebemasken ist ihre geringe Temperaturbeständigkeit, welche zur Folge hat, daß, wenn Metall bei zu hoher Temperatur aufgedampft wird, das Lackmuster verfließt, d. h. seine Dimensionen ändert. Um solche Dimensionsänderungen zu vermeiden, darf bei der mittels des in der Patentschrift beschriebenen Verfahrens hergestellten Abhebemaske die Aufdampftemperatur 120° C nicht überschreiten. Eine relativ hohe Aufdampftemperatur ist aber wünschenswert, wenn das aufgedampfte Metall mit Bereichen eines z. B. aus Halbleitermaterial bestehenden Substrats leitenden Kontakt haben soll und gefordert ist, daß der Kontaktwiderstand klein und einheitlich ist. Die gemäß dem von Freed u. a. angegebenen Verfahren hergestellte Abhebemaske hält zwar Aufdampftemperaturen von 150 bis 160° C aus, aber auch diese Temperaturen sind noch nicht zufriedenstellend hoch, außerdem kommen bei diesem Verfahren - wie dargelegt worden ist - die Komplexität des Verfahrens und des Maskenaufbaus als weitere Nachteile hinzu.

Es ist die Aufgabe der Erfindung, ein einfaches Verfahren zur Herstellung einer Abhebemaske anzugeben, welche die Vorteile der bekannten Abhebemasken aufweist und außerdem temperaturbeständig ist, und eine Anwendung der so hergestellten Maske anzugeben.

Diese Aufgabe wird mit einem Verfahren der eingangs genannten Art mit den Merkmalen des kennzeichnenden Teils des Patentanspruchs 1 und einer Anwendung gemäß Patentanspruch 7 gelöst.

Die Schritte des erfindungsgemäßen Verfahrens wirken in nicht naheliegender und bisher nicht völlig verstandener Weise zusammen, um auf einem einfachen Weg, bei dem, wenn das Maskenmuster einmal erzeugt ist, Musterdimensionen nicht mehr verändert werden, eine Abhebemaske zu erzeugen, welche aus einer Schicht besteht, in den Maskenöffnungen überhängende Wände hat und auch bei Einwirkung höherer Temperaturen dimensionsstabil ist. Die Einfachheit des Verfahrens und der damit hergestellten Maske wirkt sich nicht nur vorteilhaft bei den Herstellkosten, sondern auch bei der Defektdichte aus.

Es ist vorteilhaft, wenn bei der Temperaturbehandlung nach dem Entwickeln und Bestrahlen auf Temperaturen im Bereich zwischen 150 und 280° C, bevorzugt auf ungefähr 250° C erhitzt wird. Bei Temperaturen unter 150° C verbleiben offenbar noch Lösungsmittel- und Wasserreste in der Maske. Bei Temperaturen oberhalb 280° C beginnt das Maskenmaterial zu sublimieren.

Die erfindungsgemäß hergestellte Maske läßt sich ohne weiteres bei Temperaturen von beispielsweise 200° C mit Metall bedampfen, ohne daß sich die Maskendimensionen ändern. Dadurch ist es möglich, einerseits niedrige und einheitliche Kontaktwiderstände zu erzeugen und andererseits die Maske dann einzusetzen, wenn dicht gepackte Schaltungen mit sehr schmalen und nahe beieinanderliegenden Leiterzügen mit hoher Ausbeute erzeugt werden sollen. Offenbar aufgrund der Temperaturbehandlung nach dem Entwickeln und Belichten werden bei Verwendung der erfindungsgemäß hergestellten Maske nach dem Abheben keine Metallsäume entlang den Leiterzügen festgestellt, welche bei Verwendung einer gemäß dem in der erwähnten Patentschrift beschriebenen Verfahren hergestellten Maske auftreten. Diese Metallsäume haben zwar keinen Einfluß auf die Leitfähigkeit der Leiterzüge, dafür aber auf deren Kapazität.

Vorteilhafte Ausgestaltungen des erfindungsgemäßen Verfahrens und der erfindungsgemäßen Anwendung sind in den Unteransprüchen angegeben.

Im folgenden wird ausführlich die Herstellung der erfindungsgemäßen Abhebemaske und ihre erfindungsgemäße Anwendung beschrieben.

Bei der Herstellung der Abhebemaske wird zunächst der Positivlack mit der schwachen Base gemischt. Als schwache Base wird bei dem hier beschriebenen Verfahren 1-Hydroxyäthyl-2-alkylimidazolin eingesetzt. Das Verfahren funktioniert aber - wie oben ausgeführt wurde - nicht nur, wenn diese Verbindung verwendet wird. Geeignete Positivlackmaterialien enthalten Polyvinylphenol und einen photoaktiven Diazonaphthochinon-Inhibitor. Ein solcher Positivlack wird beispielsweise von der Firma Shipley Company, Inc., Newton, Mass., V.St.A. unter der Typenbezeichnung 23M vertrieben. Das genannte Alkylimidazolin wird von der Firma Mona Ind., Inc., Paterson, New Jersey, V.St.A. unter dem Handelsnamen Monazoline C vertrieben. Eine festgelegte Menge von Monazoline C wird in einer kleinen Menge eines Lösungsmittels, wie z. B. Cellosolveacetat, gelöst und dann mit einer so großen Menge des Positivlackmaterials vermischt, daß die Mischung zwischen etwa 1 und etwa 3 g Monazoline C pro 100 ml Mischung enthält.

Zur Erzeugung der Lackschicht wird eine kleine Menge der Mischung auf die Unterlage, auf welcher die Abhebemaske erzeugt werden soll, bevorzugt durch Aufschleudern aufgebracht. Die Dicke der aufgebrachten Schicht liegt bevorzugt zwischen etwa 1,5 und 6 μm. Die Schichtdicke wird über die Umdrehungsgeschwindigkeit des Schleudertisches gesteuert.

Anschließend wird die Lackschicht bei Temperaturen im Bereich zwischen etwa 85 und etwa 105°C zwischen etwa 10 und etwa 20 Minuten lang vorgehärtet und dann durch ein Maskenmuster hindurch bestrahlt. Zum Bestrahlen sind UV-Licht und Elektronenstrahlung geeignet. Beim Bestrahlen wird in den nicht von der Bestrahlungsmaske abgedeckten Bereichen der photoaktive Inhibitor abgebaut, und zwar beginnt die Zersetzung an der Oberfläche der Lackschicht.

Der durch das Maskenmuster hindurch bestrahlte Lackfilm wird bei Temperaturen im Bereich zwischen etwa 95 und etwa 110°C zwischen etwa 10 und etwa 60 Minuten lang erhitzt. Dabei findet in den zuvor bestrahlten Bereichen der Lackschicht eine chemische Reaktion statt, bei der offenbar das Monazoline C dort, wo der Inhibitor abgebaut worden ist, mit den Polymermolekülen des Lacks in der Weise reagiert, daß eine Vernetzung stattfindet, wobei die zuvor löslich gemachten Bereiche der Lackschicht wieder unlöslich werden. Für die Temperaturbehandlung wird ein relativ einfacher Ofen verwendet, welcher eine Einstellung der Temperatur auf ± 1°C erlaubt. Üblicherweise wird die Temperaturbehandlung in einer Stickstoffatmosphäre durchgeführt.

Nach der Temperaturbehandlung wird die Lackschicht ganz flächig bestrahlt. Dabei wird bevorzugt eine UV-Lampe hoher Intensität, wie z. B. eine 200 Watt-Quecksilber-Höchstdrucklampe verwendet. Für eine ungefähr 2 μm dicke Lackschicht sind bei Verwendung der 200 Watt-Lampe ungefähr 50 Sekunden eine vernünftige Bestrahlungsdauer. Bei der ganzflächigen Bestrahlung wird in den Bereichen, welche zuvor keiner Bestrahlung ausgesetzt waren, der Inhibitor abgebaut. Anschließend wird mit einer KOH-Lösung mit einer Normalität im Bereich zwischen 0,05 und 0,2 bei Temperaturen unterhalb 10°C, bevorzugt bei Temperaturen zwischen 0 und 10°C, entwickelt. Dabei bleiben die beim Bestrahlen durch das Bestrahlungsmuster hindurch bestrahlten Bereiche stehen, und die beim ersten Bestrahlen abgedeckten Bereiche werden weggelöst. Es entsteht also in der Lackschicht ein Lochmuster, welches den nicht transparenten Bereichen im Maskenmuster gleicht. Die erforderliche Zeit, um eine ungefähr 2 μm dicke Lackschicht zu entwickeln, liegt in der Größenordnung von 10 Minuten.

Die Wände in den Öffnungen des erzeugten Lackmusters haben den geforderten Überhang. Würde allerdings das Lackmuster auf Temperaturen oberhalb 140°C erhitzt werden, dann würden seine Kanten verfließen. Das Lackmuster wird deshalb ganz flächig einer weiteren Bestrahlung ausgesetzt, und zwar mit einer Strahlung im Wellenlängenbereich zwischen 300 und 320 nm, wobei die eingestrahlte Energie bei $\geq$ 60 Joule/cm$^2$ liegt. Durch die Bestrahlung bildet sich eine gehärtete Oberflächenhaut auf dem Lackmuster. Es ist wichtig, den angegebenen Wellenlängenbereich einzuhalten, weil bei kürzeren Wellenlängen die Absorption der Strahlung im Lack so stark ist, daß die gehärtete Oberflächenhaut sehr dünn ist und bei längeren Wellenlängen die gewünschte Härtung nicht erfolgt. Nach der Bestrahlung kann das Lackmuster auf Temperaturen im Bereich zwischen 150 und 300°C erhitzt werden, ohne daß die Kanten verfließen. Eine Temperaturbehandlung in diesem Temperaturbereich schließt sich an die Bestrahlung an. Sie hat den Zweck, im Lack noch vorhandene Lösungmittel- und Wasserreste auszutreiben. Nunmehr liegt die fertige, temperaturbeständige Abhebemaske vor.

Günstig ist es, bei der Herstellung der Abhebemaske gemäß der folgenden Ausführungsvorschrift vorzugehen:

5 g Monazoline C werden in 25 ml Cellosolveacetat gelöst, und dann werden zu dieser Lösung 225 ml des Positivlacks 23M gegeben. Vor der weiteren Verwendung der Positivlackmischung läßt man die benötigte Menge durch ein Filter laufen.

Die Positivlackmischung wird bei 2500 Upm 30 Sekunden lang auf die Unterlage aufgeschleudert. Dabei entsteht eine 2,0 bis 2,1 µm dicke Schicht. Anschließend wird die Lackschicht 20 Minuten lang bei 85°C getrocknet.

Daraufhin wird die Lackschicht durch eine Bestrahlungsmaske hindurch mit Licht der Wellenlänge 436 nm bestrahlt. Als Strahlquelle kann beispielsweise eine 350 Watt-Quecksilber-Höchstdrucklampe verwendet werden, welche von der Firma Osram unter der Typenbezeichnung HBO 350 vertrieben wird. Die Festlegung der optimalen Bestrahlungszeit erfolgt in der Weise, daß mehrere Proben verschieden lang belichtet werden, dann die beim Entwickeln erhaltenen Maskendimensionen gemessen und mit den Dimensionen des Bestrahlungsmaskenmusters verglichen werden. Die optimale Bestrahlungszeit ist dann diejenige, bei der das Muster der nicht transparenten Bereiche der Bestrahlungsmaske mit dem Muster der Öffnungen in dem erzeugten Lackmuster völlig übereinstimmt. Nach dem bildmäßigen Belichten wird die Lackschicht einer Temperaturbehandlung bei 100°C, welche etwa 50 Minuten dauert und in einer Stickstoffatmosphäre stattfindet, unterworfen. Dann wird die Lackschicht ganzflächig bestrahlt. Dazu kann beispielsweise eine von der Firma Osram unter der Typenbezeichnung HBO 200 vertriebene Quecksilber-Höchstdrucklampe verwendet werden.

Anschließend wird mit einer 0,13 normalen KOH-Lösung bei einer Temperatur zwischen etwa 5 und etwa 7°C ungefähr 10 Minuten lang entwickelt.

Das erzeugte Lackmuster wird, beispielsweise mittels eines Xe-Cl-gefüllten Excimer-Lasers, mit Licht der Wellenlänge 308 nm bestrahlt, wobei größenordnungsmäßig 60 Joule/cm² eingestrahlt werden.

Danach wird das Lackmuster in einem Ofen unter Stickstoff gehärtet, wobei bevorzugt auf ungefähr 250°C erhitzt wird. Es findet dabei keinerlei Verfließen der Lackkanten statt.

Die nunmehr vorliegende Abhebemaske hat Öffnungen, deren Wände überhängend sind, und sie kann auch noch bei 250°C mit Metall bedampft werden, ohne daß eine Dimensionsänderung stattfindet.

Die erfindungsgemäße Anwendung der erfindungsgemäß hergestellten Abhebemaske wird im folgenden am Beispiel der Herstellung von Leiterzugmustern auf Halbleitersubstraten besprochen. Dabei ist die Temperaturbeständigkeit der Abhebemaske wichtig. Es sei aber klargestellt, daß die Anwendung der Abhebemaske nicht auf dieses Beispiel beschränkt ist. Vielmehr lassen sich mit Hilfe der Abhebemaske auch Leiterzugmuster beispielsweise auf Keramikmoduln erzeugen. Außerdem können auch Muster erzeugt werden, welche keine Leiterzugmuster sind. Das Muster kann aus jedem Material erzeugt werden, welches mittels eines Verfahrens, bei dem alle Materialpartikel etwa aus derselben Richtung auf dem Substrat auftreffen - zu diesen Verfahren gehören das Aufdampfen und die Kathodenzerstäubung -, aufgebracht werden kann.

Das Halbleitersubstrat, auf dem ein Leiterzugmuster erzeugt werden soll, ist üblicherweise mit einer Isolierschicht bedeckt. Auf dieser wird die Abhebemaske erzeugt. Im Halbleitersubstrat sind in vorangegangenen Verfahrensschritten Halbleiterbauteile erzeugt worden, welche mittels des herzustellenden Leiterzugmusters untereinander und mit peripheren Anschlüssen verbunden werden sollen. Deshalb müssen in die Isolierschicht vor dem Aufbringen des Leiterzugmaterials Kontaktlöcher zum Halbleitersubstrat geätzt werden. Diese Kontaktlöcher werden entweder unter Verwendung der Abhebemaske als Ätzmaske geätzt (ein solches Verfahren ist beispielsweise in der europäischen Patentanmeldung 0 057 738 beschrieben) oder sind bereits vorhanden, wenn die Lackschicht zu Beginn der Erzeugung der Abhebemaske aufgebracht wird. Im folgenden wird der letztere Fall zugrundegelegt, d. h. bei der Beschreibung der erfindungsgemäßen Anwendung der Abhebemaske wird davon ausgegangen, daß diese erfindungsgemäß auf einer Kontaktlöcher aufweisenden Isolierschicht, welche auf einem ebenen Halbleitersubstrat aufliegt, hergestellt worden ist.

Auf die Abhebemaske wird ganzflächig ein leitfähiges Material, wie z. B. ein Metall, senkrecht zur Oberfläche des Halbleitersubstrats aufgedampft. Das Substrat ist dabei auf eine Temperatur im Bereich zwischen etwa 160 und 250°C aufgeheizt. Es wird solange aufgedampft, bis das aufgebrachte Material, beispielsweise eine Legierung aus Aluminum und Kupfer, etwa 1 µm, d. h. etwa halb so dick wie die Abhebemaske ist. Wegen des Überhängens der Wände in den Öffnungen der Abhebemaske und der Art des Aufbringens wird kein Material auf den Wänden der Öffnungen niedergeschlagen. Deshalb kann das Lösungsmittel, welches die Abhebemaske auflösen soll, ungehindert von der Seite her angreifen. Zwar ist es nach dem Metallbedampfen bei der relativ hohen Temperatur nicht mehr möglich, die Abhebemaske in den herkömmlichen organischen Lösungsmitteln aufzulösen, es ist aber festgestellt worden, daß sich das Abhebemaskenmaterial in einer wässrigen Natriummetasilicat-($NaSiO_3 \cdot xH_2O$)-Lösung auflösen läßt. Die Lösung wird bei Raumtemperatur angewandt und sollte $\leqslant 0,25$

molar sein. Gleichzeitig mit dem Auflösen der Abhebemaske wird das auf der Maske abgeschiedene leitfähige Material abgehoben. Übrig bleibt das in den Öffnungen der Abhebemaske direkt auf der Isolierschicht bzw. in den Kontaktlöchern abgeschiedene leitfähige Material, welches das gewünschte Leiterzugmuster darstellt. Sollten noch Lackreste auf dem Substrat nach dem Abheben vorhanden sein, so können diese rasch und problemlos in einem Sauerstoffplasma entfernt werden.

Das erzeugte Leiterzugmuster entspricht innerhalb kleiner Toleranzen in allen seinen Abmessungen dem gewünschten Muster. Dies trifft auch zu, und zwar mit außerordentlich guter Reproduzierbarkeit, wenn das Leiterzugmuster dicht gepackt ist, d. h. sehr schmale Leiterzüge ($\geqslant 1 \mu m$) mit geringem Abstand ($\geqslant 1 \mu m$) aufweist. Die Kontaktwiderstände in den Kontaktlöchern sind niedrig und einheitlich. Außerdem werden keinerlei Metallsäume entlang den Leiterzügen festgestellt.

Dicht gepackte Leiterzugmuster auf Halbleiterplättchen mit den erwähnten vorteilhaften Eigenschaften wurden beispielsweise gemäß der folgenden Verfahrensvorschrift hergestellt:

Auf mehreren Halbleiterplättchen, die mit einer Kontaktlöcher aufweisenden Isolierschicht bedeckt waren, wurden zunächst gemäß dem oben angegebenen Verfahren Abhebemasken erzeugt. Anschließend wurde bei einer Temperatur der Halbleiterplättchen von ungefähr 200° C im Vakuum eine etwa 1 μm dicke Al/Cu-Schicht ganzflächig aufgedampft. Die bedampften Halbleiterplättchen wurden bei Raumtemperatur in einer ungefähr 0,25 molaren, wässrigen Natriummetasilicat-Lösung 10 Minuten lang behandelt. Dabei wurde die Abhebemaske entfernt und das auf ihr liegende Al/Cu abgehoben. Zurück blieb das Leiterzugmuster auf den Isolierschichten und in den Kontaktlöchern. Die so behandelten Halbleiterplättchen wurden inspiziert, wobei auf zwei der Halbleiterplättchen geringe Lackreste festgestellt wurden. Zur Entfernung dieser Lackreste wurden die beiden Halbleiterplättchen in einem Plasmaätzgerät, welches von der LFE Corporation unter der Typenbezeichnung 301 vertrieben wird, bei einem Sauerstoffdruck von ungefähr 1,333 mbar bei einer Leistung von 150 Watt 10 Minuten lang behandelt. Bei der abschließenden Inspektion waren auch diese beiden Halbleiterplättchen völlig frei von Lackresten, und auch die auf ihnen erzeugten Leiterzugmuster zeigten alle die oben erwähnten vorteilhaften Eigenschaften. Insbesondere hatten die Leiterzugmuster auf allen prozessierten Halbleiterplättchen dieselben Dimensionen.

## Patentansprüche

1. Verfahren zum Herstellen einer Abhebemaske, bei dem ein eine schwache Base enthaltender Positivlack auf ein Substrat aufgebracht, bildmäßig bestrahlt, gehärtet, ganz flächig bestrahlt und entwickelt wird,
dadurch gekennzeichnet,
daß ein Positivlack verwendet wird, welcher als filmbildende Komponente Polyvinylphenol enthält, daß mit einer KOH-Lösung bei einer Temperatur < 10° C entwickelt wird, daß nach dem Entwickeln das Lackmuster mit Licht, dessen Wellenlänge im Bereich zwischen 300 und 320 nm liegt, bestrahlt und anschließend auf eine Temperatur im Bereich zwischen 150 und 280° C erhitzt wird.

2. Verfahren nach Anspruch 1,
dadurch gekennzeichnet,
daß bei Temperaturen im Bereich zwischen 0 und 10° C mit einer zwischen 0,05 und 0,2 normalen KOH-Lösung entwickelt wird.

3. Verfahren nach Anspruch 2,
dadurch gekennzeichnet,
daß mit einer 0,13 normalen KOH-Lösung entwickelt wird.

4. Verfahren nach einem oder mehreren der Ansprüche 1 bis 3,
dadurch gekennzeichnet,
daß das Lackmuster mit Licht der Wellenlänge 308 nm bestrahlt wird.

5. Verfahren nach einem der Ansprüche 1 bis 4,
dadurch gekennzeichnet,
daß das Lackmuster mit $\geqslant 60$ mJ/cm$^2$ bestrahlt wird.

6. Verfahren nach einem der Ansprüche 1 bis 5,
dadurch gekennzeichnet,
daß als schwache Base 1-Hydroxyäthyl-2-alkylimidazolin eingesetzt wird.

7. Anwendung der mittels des Verfahrens nach einem oder mehreren der Ansprüche 1 bis 6 hergestellten Abhebemaske zum Erzeugen eines Leiterzugmusters, bei der die Maske ganz flächig mit einem leitfähigen Material bedampft wird und dann die Abhebemaske in einem Lösungsmittel gelöst und damit das auf ihr liegende leitfähige Material abgehoben wird,
dadurch gekennzeichnet,
daß als Lösungsmittel eine wässrige Natriummetasilicat-Lösung verwendet wird.

8. Anwendung nach Anspruch 7,
dadurch gekennzeichnet,
daß eine $\leqslant 0,25$ molare Natriummetasilicat-Lösung zum Auflösen der Abhebemaske eingesetzt wird.

9. Anwendung nach Anspruch 7 oder 8,
dadurch gekennzeichnet,
daß ein Leiterzugmuster aus Metall auf einem mit einer Kontaktlöcher aufweisenden Isolierschicht abgedeckten Halbleitersubstrat erzeugt wird.

10. Anwendung nach Anspruch 9,
dadurch gekennzeichnet,
daß das Metall bei einer Substrattemperatur im Bereich zwischen etwa 160 und etwa 250° C, bevorzugt von 200° C, aufgedampft wird.

## Claims

1. Method for producing a lift-off mask, wherein a positive resist containing a weak base is deposited on a substrate, exposed imagewise, cured, blanket exposed and developed, characterized in that a positive resist is used containing polyvinyl phenol as a film forming component, that development is effected in a KOH solution at a temperature of $< 10°C$, that after development, the resist pattern is exposed, using light having a wavelength ranging from 300 to 320 nm, and subsequently heat-treated at a temperature ranging from 150 to 280°C.

2. Method according to claim 1, characterized in that development is effected at temperatures ranging from 0 to 10°C, using a KOH solution whose normality ranges from 0.05 to 0.2.

3. Method according to claim 2, characterized in that development is effected in a KOH solution having a normality of 0.13.

4. Method according to any one or a combination of the claims 1 to 3, characterized in that the resist pattern is exposed to light having a wavelength of 308 nm.

5. Method according to any one of the claims 1 to 4, characterized in that the resist pattern is exposed at an energy density of $\geqslant 60\ mJ/cm^2$.

6. Method according to any one of the claims 1 to 5, characterized in that 1-hydroxyethyl-2-alkylimidazoline is used as a weak base.

7. Application of the lift-off mask produced by means of the method according to any one or a combination of claims 1 to 6 for generating a conductor pattern, comprising the steps of blanket depositing a conductive material on the mask and then dissolving the lift-off mask in a solvent, causing the conductive material deposited on the mask to be lifted off, characterized in that an aqueous sodium metasilicate solution is used as a solvent.

8. Application according to claim 7, characterized in that a $\leqslant 0.25$ molar sodium silicate solution is used to dissolve the lift-off mask.

9. Application according to claim 7 or 8, characterized in that a metal conductor pattern is generated on a semiconductor substrate covered with an insulating layer provided with contact holes.

10. Application according to claim 9, characterized in that the metal is vapor deposited at a substrate temperature ranging from about 160 to about 250°C, preferably at 200°C.

## Revendications

1. Procédé de fabrication d'un masque d'enlevage dans lequel un vernis positif contenant une base faible est appliqué sur un substrat, exposé à la manière d'une image, durci, exposé à un rayonnement sur toute sa surface et développé, caractérisé en ce qu'on utilise un vernis positif qui contient du polyvinylphénol comme constituants formant un film, en ce que l'on développe avec une solution de KOH à une température $< 10°C$, en ce qu'après le développement, le dessin au vernis est exposé à une lumière dont la longueur d'onde se situe entre 300 et 320 nm, puis chauffé à une température comprise entre 150 et 280°C.

2. Procédé selon la revendication 1, caractérisé en ce qu'aux températures comprises entre 0 et 10°C, on développe dans une solution normale de KOH comprise entre 0,05 et 0,2.

3. Procédé selon la revendication 2, caractérisé en ce qu'on développe avec une solution normale de KOH à 0,13.

4. Procédé selon une ou plusieurs des revendications 1 à 3, caractérisé en ce que le dessin au vernis est exposé à une lumière de longueur d'onde égale à 308 nm.

5. Procédé selon l'une des revendications 1 à 4, caractérisé en ce que le dessin au vernis est exposé à un rayonnement $\geqslant 60\ mJ/cm^2$.

6. Procédé selon l'une des revendications 1 à 5, caractérisé en ce qu'on utilise comme base faible une 1-hydroxyéthyl-2-alkylimidazoline.

7. Mise en oeuvre du masque d'enlevage réalisé au moyen du procédé selon une ou plusieurs des revendications 1 à 6, en vue de produire un circuit imprimé, dans laquelle on vaporise sur toute la surface du masque une matière conductrice, puis on dissout le masque d'enlevage dans un solvant, ce qui fait que la matière conductrice déposée sur celui-ci est enlevée, caractérisée en ce que l'on utilise comme solvant une solution aqueuse de métasilicate de sodium.

8. Mise en oeuvre selon la revendication 7, caractérisée en ce que l'on utilise une solution $\leqslant$ 0,25 molaire de métasilicate de sodium pour dissoudre le masque d'enlevage.

9. Mise en oeuvre selon la revendication 7 ou 8, caractérisée en ce qu'un circuit en métal est produit sur un substrat semiconducteur recouvert d'une couche isolante présentant des trous de contact.

10. Mise en oeuvre selon la revendication 9, caractérisée en ce que le métal est vaporisé à une température du substrat comprise entre 160 et environ 250°C, de préférence égale à 200°C.